Europäisches Patentamt

European Patent Office

Office européen des brevets

(19)

(11) Publication number: **0 434 330 A2**

# (12) EUROPEAN PATENT APPLICATION

(21) Application number: **90313746.1**

(22) Date of filing: **17.12.90**

(51) Int. Cl.⁵: **H01J 1/30, H01J 9/02, H01J 3/02**

(30) Priority: **18.12.89 JP 327621/89**

(43) Date of publication of application:
**26.06.91 Bulletin 91/26**

(84) Designated Contracting States:
**DE FR GB NL**

(71) Applicant: **SEIKO EPSON CORPORATION**
**4-1, Nishishinjuku 2-chome**
**Shinjuku-ku Tokyo (JP)**

(72) Inventor: **Komatsu, Hiroshi, c/o Seiko Epson**
**Corporation**
**3-5 Owa 3-chome, Suwa-shi**
**Nagano-ken (JP)**

(74) Representative: **Caro, William Egerton et al**
**J. MILLER & CO. Lincoln House 296-302 High**
**Holborn**
**London WC1V 7JH (GB)**

(54) **Field emission device and process for producing the same.**

(57)    The present invention provides a field emission device and a process for producing the same. The device comprises a cathode (2) projecting from the surface of a substrate (1), an insulating layer (3) provided on the surface of the substrate, which insulating layer is open at the location of the cathode, and a gate electrode (4) provided on the surface of the insulating layer, which gate electrode is open at the location of the cathode. In the production of the device, the cathode and the insulating layer are fabricated by forming both from a layer of a material by supplying insulating impurities into a portion only of the layer of material for forming the insulating layer whilst leaving another portion of the layer of material as the cathode. Consequently, the cathode and the insulating layer are formed from the same basic material and the same basic layer, which is advantageous from a manufacturing point of view.

FIG. 2

EP 0 434 330 A2

# FIELD EMISSION DEVICE AND PROCESS FOR PRODUCING THE SAME

This invention concerns the construction and production of a field emission device that emits electrons as a result of an applied electric field. The invention relates particularly to a field emission device for providing an electronic source for luminous display devices, for optical printer heads, for multiple-electrode electronic devices and for x-ray generating devices and the like.

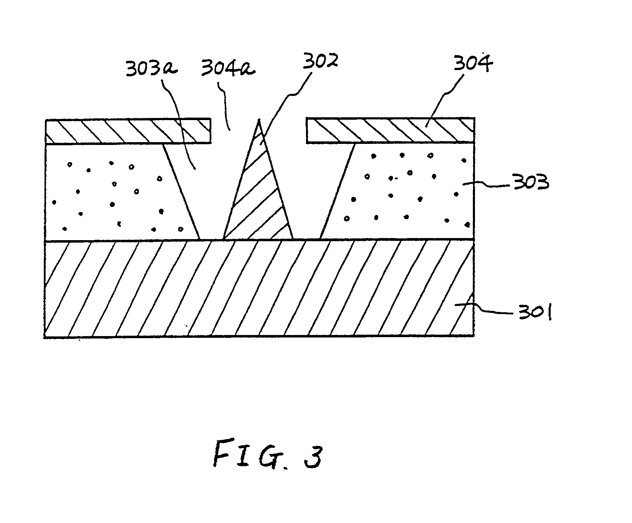

A field emission device and a process for producing such a device are known from an article by C. A. Spindt et al in the Journal of Applied Physics, vol. 47, No. 12, (1976). The accompanying Figure 3 is a cross sectional view of the prior Spindt-type field emission device. This field emission device comprises an insulating layer 303 and a gate electrode 304 deposited on the surface of a low resistance silicon (Si) substrate 301. A cone shaped cathode 302 is fabricated on the surface of the silicon substrate 301 at openings 303a and 304a provided in the insulating layer 303 and the gate electrode 304, respectively. The film thickness of the insulating layer 303 and the gate electrode 304 are 1.5 microns and 0.4 microns, respectively. The opening in the gate electrode 304 has a diameter of 1.5 microns and the height of the cathode 302 is about 1.9 microns.

As for the production of this field emission device, after depositing the insulating layer 303, composed of silicon dioxide (SiO2) on the surface of the silicon substrate 301 and continuously depositing the gate electrode 304, which is made of molybdenum (Mo), using a sputtering process, a gate photo-etching process is used on the gate electrode 304 and the insulating layer 303 to create the gate electrode opening 304a and the insulating layer opening 303a in the gate electrode 304 and the insulating layer 303, respectively. Subsequent to this, a molybdenum layer is deposited over the entire surface by means of sputtering. Making use of each of the openings, the cone shaped cathode 302, which is automatically aligned with the openings 303a and 304a, is fabricated on the surface of the silicon substrate 301. Finally, the unnecessary molybdenum on the surface of the gate electrode 304 is removed by means of electro-chemical etching, thus completing the production process.

However, the field emission device and its production according to the prior art has a number of problems, as listed below :

(1) When fabricating cathodes over the entire surface of a flat substrate with a large surface area, the sputtering or vapour deposition has a particle source, which is smaller than the substrate surface area, and the angle range of the particles directed to the substrate surface will differ in the central and peripheral regions of the substrate. As a result, the angle between the vertical axis of the cathode and the flat substrate has an in-surface distribution. That distribution appears in the threshold voltage and current density of the field emission device, which are dependent upon the distance between the cathode and the gate electrodes.

(2) In addition, in the production step that forms the cathode, it is difficult to maintain the shape of the cathode because the etching of the unnecessary molybdenum and the cathode takes place simultaneously in a single electro-chemical etching step that follows the molybdenum sputtering, and this reduces production yield.

It is an object of this invention to provide a field emission device and a production process therefor that allows high yield fabrication of cathodes, even on a substrate with a large surface area.

In accordance with a first aspect of the present invention, there is provided a field emission device comprising a substrate, a cathode projecting on the surface of the substrate, an insulating layer provided on the surface of the substrate, which insulating layer is open at the location of the cathode, and a gate electrode provided on the surface of the insulating layer, which gate electrode is open at the location of the cathode, characterised in that the insulating layer and the cathode comprise the same basic material with the insulating layer containing insulating impurities for converting the material into an insulating material.

In accordance with a second aspect of the present invention, there is provided a process for producing a field emission device comprising fabricating a cathode projecting from the surface of a substrate, fabricating an insulating layer on the surface of the substrate, which insulating layer is open at the location of the cathode, and fabricating a gate electrode on the surface of the insulating layer, which gate electrode is open at the location of the cathode, characterised in that the steps of fabricating the cathode and the insulating layer comprise forming both the cathode and the insulating layer from a layer of a material by supplying insulating impurities into a portion only of said layer of material for forming the insulating layer whilst leaving another portion of said layer of material as the cathode.

The present invention will be described further, by way of example, with reference to the accompanying drawings, in which :—

Figures 1 (a) and 1 (b) are a plan view, and a cross sectional view along the line A - A' of the plan view, showing a field emission device according to a first embodiment of the present invention, which is produced by means of thermal oxidation on a single crystal silicon substrate ;

Figures 2 (a) to 2 (e) are cross sectional views showing the process steps for producing the field emission device shown in Figure 1 ;

Figure 3 is a cross sectional view of a prior art field emission device ;

Figures 4 (a) to 4 (d) are cross sectional views showing the process steps of a second process for producing the field emission device using a reverse taper diffusion mask ;

Figures 5 (a) and 5 (b) are cross sectional views of two alternative diffusion masks composed of multiple layers ;

Figures 6 (a) to 6 (e) are cross sectional views showing the process steps for producing a further field emission device, in which the height of the cathode is increased ;

Figures 7 (a) and 7 (b) are a plan view of a further field emission device and a cross sectional view along the line D - D' of the plan view ;

Figure 8 is a cross sectional view of another embodiment of the field emission device having an insulating substrate ;

Figures 9 (a) to 9 (c) are cross sectional views showing an additional process step for use in the production of a field emission device according to the present invention ;

Figure 10 is a cross sectional view of a further embodiment of the field emission device having a barium thin film layer fabricated on the tip of the cathode ;

Figures 11 (a) and 11 (b) are a plan view of a vertical three-electrode device and a cross sectional view along the line G - G' of the plan view ;

Figures 12 (a) and 12 (b) are a plan view of a horizontal three-electrode device and a cross sectional view along the line H - H' of the plan view ;

Figure 13 is a graph showing the static characteristics of the voltage to current (V - I) properties of the vertical three-electrode device ;

Figure 14 is a circuit diagram of a linear amplifier using the vertical three-electrode device ;

Figure 15 is a partial isometric drawing of a simple matrix luminous display device ;

Figure 16 is a partial isometric drawing of an active matrix luminous display device ;

Figure 17 is a schematic plan view of the device of Figure 16 ; and

Figures 18 (a) and 18 (b) are a plan view of a monochrome optical printer head and a cross sectional view along the line J - J' of the plan view.

A field emission device according to the present invention fabricated by means of thermal oxidation of a single crystal silicon substrate will be described first.

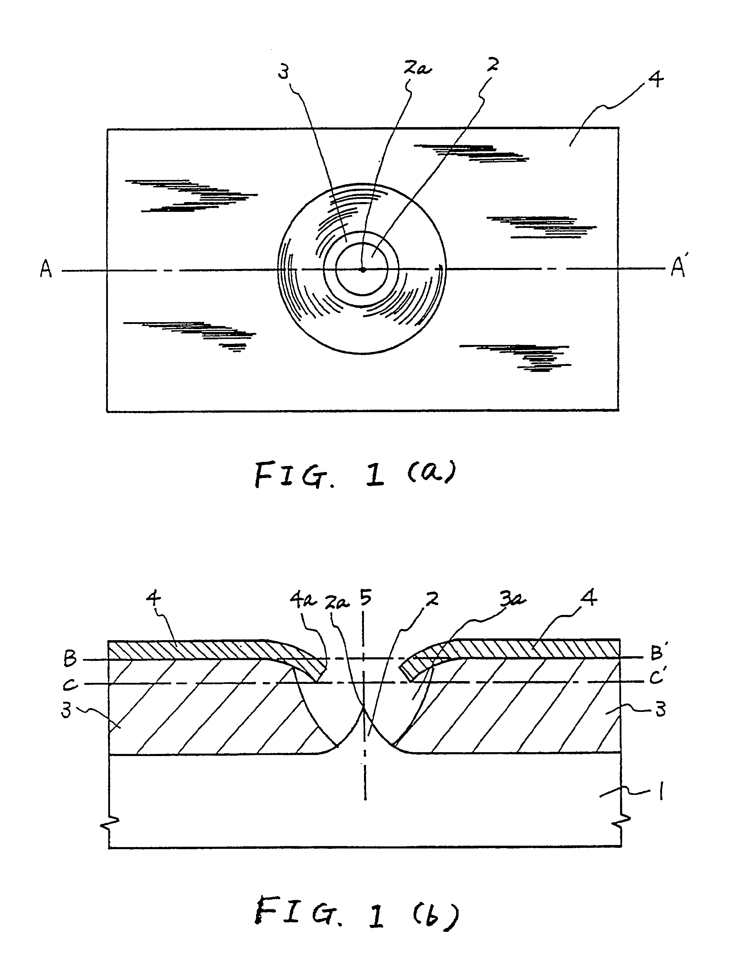

The construction of the field emission device is shown in Figure 1 (a) and Figure 1 (b). This field emission device comprises a flat single crystal silicon substrate 1, a cone shaped cathode 2 fabricated on the surface of the substrate 1, an insulating layer 3 that is fabricated on the surface of the substrate 1 and is opened at the location of the cathode 2, and a gate electrode 4 that is fabricated on the surface of the insulating layer 3 and is also opened at the location of the cathode 2.

The substrate 1 is a single crystal silicon substrate with a (100)-oriented surface and n-type conduc-tivity having a carrier concentration of $1 \times 10^{19}$ cm$^{-3}$. The cathode 2 is fabricated of the same n-type single crystal silicon as the substrate and is integral with the substrate 1. The cathode 2 has a height of about 2400 Å and is generally cone shaped. Moreover, the projecting tip 2a of the cathode 2 comes to an acute angle at a radius of curvature of about 1000 Å or less.

The insulating layer 3 is composed of a silicon dioxide material that is fabricated by means of thermal oxidation of the substrate 1. That is, the insulating layer 3 contains silicon, the material of the cathode, and oxygen (O), the insulating impurity component that converts the silicon into silicon dioxide. The film thickness of the insulating layer 3 is 5000 Å and its direct break down field is about 8 MV per centimetre. The gate electrode 4 is a molybdenum thin film with a thickness of 1000 Å. Above the cathode 2, a circular gate electrode opening 4a has been created that is centered on the perpendicular axis 5 of the cathode 2. The gate electrode opening 4a above the cathode 2 has a diameter of about 4000 Å. In addition, the gate electrode 4 is constructed so that it bends in the direction of the cathode 2 at the opening.

An insulating layer opening 3a has been created in the insulating layer 3 below the gate electrode 4 so that the cathode 2 is exposed. The projecting tip 2a of the cathode 2 is located closer to the substrate 1 than the virtual surface B - B' of the insulating layer 3, which is the upper plane of the insulating layer 3, and also closer to the substrate 1 than the virtual surface C - C' of the gate electrode at the inner periphery defining the gate electrode opening 4a, which is generally stipulated. The shortest distance between the projecting tip 2a and the gate electrode 4 is about 2700 Å.

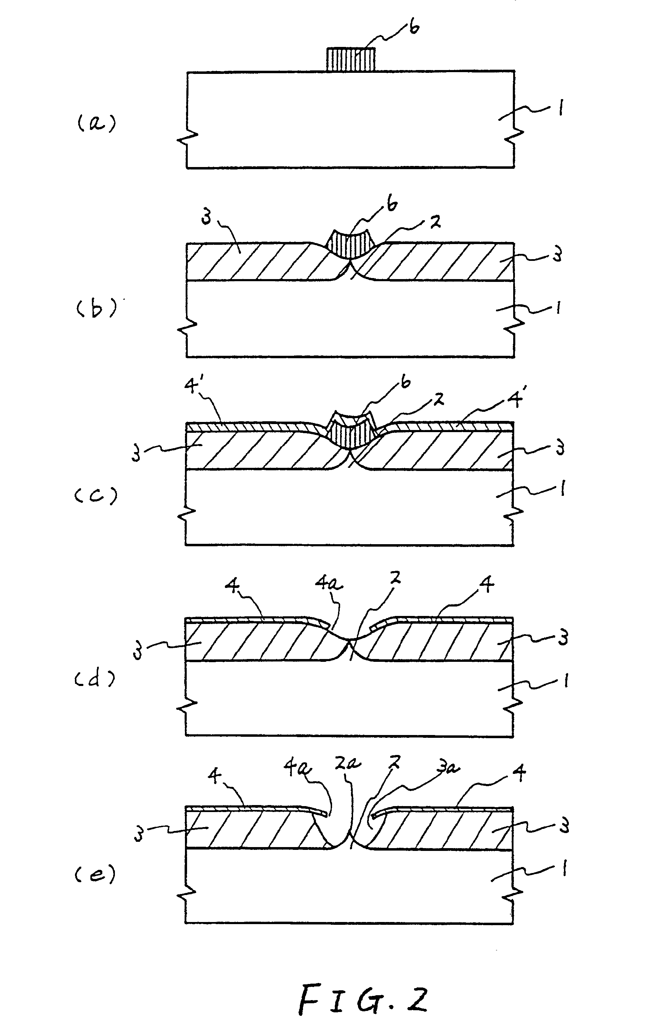

The production of the field emission device will be described next. Figures 2 (a) to 2 (e) are cross sectional views showing the product of each of the main production steps of the process.

In the first production step, an n-type single crystal silicon substrate 1, which is 700 microns thick and 15.24 cm (6 inches) in diameter is provided. A diffusion mask 6 is then fabricated from a silicon nitride film (Si3N4) in each location where a cathode 2 is to be formed on the substrate 1. The silicon nitride film is deposited using thermal CVD (chemical vapour deposition) and has a film thickness of 3000 Å. The film is then processed by means of photo-etching to form the diffusion mask 6 with a cylindrical or truncated cone shape having a base diameter of about 5000 Å. The diffusion mask 6 has walls with a normal tapered shape (Figure 2 (a)) that extend at 90° or less relative to the surface of the substrate 1. The diffusion mask may have an alternative shape other than the described cylinder or truncated cone. For example, it may also be a truncated pyramid or a truncated elliptical cone.

Next, in the second step of the process, thermal oxidation is used to diffuse oxygen, as an insulating impurity, into regions of the substrate that are not masked by the diffusion mask 6. This is done in order to form a silicon dioxide insulating layer 3 and to form a cathode 2 in the region that is covered by each diffusion mask. In order to prevent the invasion of oxygen from the surface, the diffusion mask 6 is employed. Oxidation takes place primarily in a direction perpendicular to the surface of the substrate in regions that have no diffusion mask 6. However, in regions that have a diffusion mask 6, oxidation does not take place in the perpendicular direction.

Instead, oxidation takes place horizontally from the edge of the diffusion mask 6. As a result, a silicon dioxide film is fabricated partially under the diffusion mask 6, leaving a conical silicon protrusion that is automatically aligned with the diffusion mask 6. This silicon protrusion is the cathode 2. Preferably, the substrate 1 is heated to 1100°C and vapour oxidation takes place for thirty minutes, to produce a silicon dioxide insulating layer 3, which is 5000 Å in thickness, on the surface of the substrate 1. The cathode 2 may then have a lower surface or base diameter of 5000 Å. The periphery of the diffusion mask 6 is pushed up by the silicon dioxide layer 3 and its upper surface curves upward in a concave form. In addition, an SiON film is formed on the upper surface (Figure 2 (b)).

Next, in the third production step, a molybdenum gate electrode layer 4' is fabricated on the surface of the insulating layer 3 and the diffusion mask 6 by means of a sputtering process. The thickness of the gate electrode layer 4' on the surface of the insulating layer 3 and the diffusion mask 6 is 2000 Å. The thickness of the layer 4' on the walls of the diffusion mask 6 is about 800 Å (Figure 2 (c)).

After this, in the fourth production step, the gate electrode opening 4a, which is automatically aligned with the cathode 2, is fabricated. First of all, in order to expose the walls of the diffusion mask 6, a thickness of 1000 Å is removed from the surface of the molybdenum by means of dry etching. Accordingly, the molybdenum on the walls of the diffusion mask 6 is completely removed and a portion of the gate electrode layer 4', which is 1000 Å thick, is left on the upper surface of the diffusion mask and on the insulating layer 3. Next, the exposed walls of the diffusion mask 6 are etched away with a thermal phosphoric acid solution. At this time, the molybdenum on the upper surface of the diffusion mask 6 is also lifted off and removed. The gate electrode 4 in which there is a gate electrode opening 4a that is automatically aligned with the cathode 2 is fabricated in this manner. The diameter of the gate electrode opening 4a is about 4000 Å (Figure 2 (d)).

In the fifth and final production step, an opening is made in the insulating layer 3 and the cathode 2 is exposed. Because an HF buffer solution will not dissolve molybdenum or silicon but will dissolve silicon dioxide, this solution is used to etch away the insulating layer 3 that is exposed at the location of the gate electrode opening 4a. This forms the insulating layer opening 3a and exposes the cathode 2 (Figure 2 (e)).

In a field emission device produced by such a process, the shortest distance between the cathode 2 and the gate electrode 4 is about 2700 Å, The variation in a 15.24 cm (6 inch) substrate is very small, within plus or minus 2%. The extent of this variation reflects the horizontal oxidation rate of the silicon substrate at the lower surface of the diffusion mask 6. Variation can be further reduced by making the substrate temperature uniform during the thermal oxidation.

The electrical properties of a field emission device produced in this manner were measured in a high level vacuum ($1 \times 10^{-7}$ or less). When the gate voltage $V_{gk}$, at which the cathode current Ik is Ik = 1 uA, is made the threshold voltage $V_{th}$ of the device, the threshold voltage in this embodiment is $V_{th}$ = 80 V.

In addition, the variation is within plus or minus 5%. The variation of the threshold voltage depends on the surface conditions of the cathode 2. This will improve even further by cleaning that surface in a vacuum. In order to reduce the threshold voltage, it is only a matter of further shortening the distance between the cathode 2 and the gate electrode 4. To do this, a method of decreasing the thickness of the insulating layer 3 has been considered. However, in addition to this, in the production process, it is effective to reduce the diameter of the diffusion mask 6 and hence the gate electrode opening 4a, by etching away the SiON film that has been fabricated on the surface of the mask before fabricating the gate electrode layer 4'.

In this example, silicon dioxide was used as the material for the insulating layer. However, the invention is not limited to silicon dioxide. For example, materials such as silicon nitrides (SiNx) or silicon-oxygen-nitride (SiON), in which nitrogen and oxygen is diffused, may also be used.

Likewise, thermal oxidation was used to form the insulating layer. However, it goes without saying that the diffusion of insulating impurities by means of ion implantation and anodic oxidation are also suitable

In addition, other materials may also be employed for the insulating layer. That is, a p-type single crystal silicon substrate may be used as the flat substrate 1, and a p-n junction depletion layer, fabricated on the surface of the substrate 1 between the substrate and an n-type silicon layer, can also become the insulating layer. In this case, the cathode would comprises p-type silicon and the insulating layer, for example, could contain phosphorous as an insulating impurity.

When the impurity concentration of p-type single crystal silicon is $1 \times 10^{15}$ cm$^{-3}$, the break down voltage of the p-n junction depletion layer is about 300 volts. At this time, it has sufficient resistance to the insulating layer of the field emission device. The n-type silicon layer fabricated on the surface may also be used as the gate electrode. Further, the insulating layer may be of a stacked construction with the silicon dioxide layer.

Furthermore, in addition to or instead of using molybdenum as the gate electrode 4, metals such as titanium (Ti), chromium (Cr), aluminium (Al) and tantalum (Ta) and silicides and semi-conductor materials may also be used.

Also, the n-type single crystal silicon substrate used as the substrate 1 may be replaced by a semi-conductor substrate such as a p-type single crystal silicon substrate, a germanium substrate, a gallium arsenide substrate and a metal substrate, for example an aluminium substrate.

A second embodiment, in which the production process uses a reverse taper or visor shape for the diffusion mask, for the production of the field emission device will now be described.

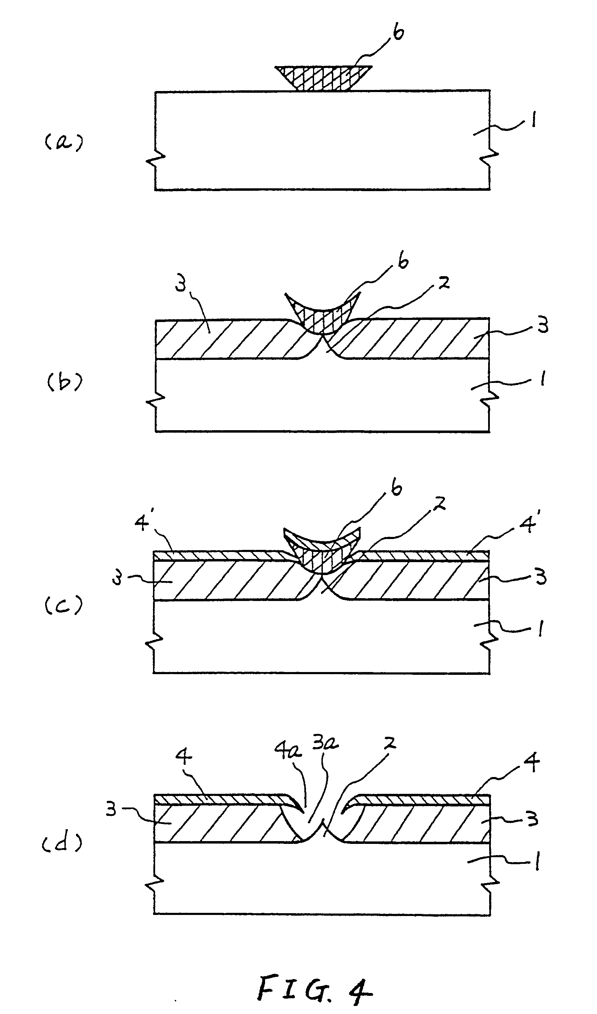

Figures 4 (a) to 4 (d) are cross sectional views showing the product of each of the main production steps of this second process for producing the field emission device using the diffusion mask with the reverse taper shape.

First, a reverse taper diffusion mask 6 is fabricated on the surface of the substrate 1. The diffusion mask 6 is produced by depositing a silicon dioxide layer, that is 5000 Å thick, on the surface of the substrate 1 by means of thermal CVD and photo-etching and processing this layer to form a reverse taper shape. The mask has a reverse truncated cone shape with a lower or base surface, which is 0.5 microns in diameter. That surface comes into contact with the substrate 1. The mask also has an upper surface, which is 1.5 microns in diameter. The silicon dioxide layer, which is deposited by means of thermal CVD, has a weak cohesion with the substrate 1. If an HF-type wet etch takes place in a condition in which there is a strong adhesive bond with the resist employed, the etching at the interface with the substrate 1 will progress rapidly and a reverse taper diffusion mask will be fabricated (Figure 4 (a)).

Next, in the second production step, the insulating layer 3 is fabricated, just as in the second production step of Figure 2 (b) (Figure 4 (b)).

Next, in the third production step, the gate electrode layer 4' is formed by means of a directional particulate deposition process. The directional particulate deposition process accelerates particles in a direction generally perpendicular to the surface of the substrate 1 to deposit the gate electrode layer 4'. If this process is used, particles will not be deposited on the walls of the diffusion mask 6 because the reverse taper shape of the diffusion mask 6 shadows the walls from depositing particles, which is called a visor effect herein. The gate electrode layer 4' will then be divided between the surface of the diffusion mask 6 and the surface of the insulating layer 3.

In this embodiment, electron beam vapour deposition is used as the directional particulate deposition process. Molybdenum particles are deposited at a film thickness of 1000 Å to form the gate electrode layer 4' (Figure 4 (c)). In addition to vapour deposition for the directional particulate deposition process, sputtering and ECR plasma deposition can also be used.

Next, in the fourth and fifth production steps, the gate electrode opening 4a and the insulating layer opening 3a are fabricated consecutively, automatically aligning with the cathode 2. The substrate 1 is placed in a HF buffer solution. At the location of the cathode 2, the diffusion mask 6 and the insulating layer 3 are etched away consecutively, exposing the cathode 2. At this time, the molybdenum on the surface of the diffusion mask is also lifted away (Figure 4 (d)).

The production process in this embodiment leaves the walls of the diffusion mask exposed by employing the directional particulate deposition process. Thus, the third production step in the previous embodiment, in which the molybdenum surface is removed in portions to expose the diffusion mask walls, is unnecessary. Moreover, because the diffusion mask 6 and the insulating layer 3 are composed of the same material, there is the excellent feature of being able to use the same process to form consecutively the gate electrode opening 4a and the insulating layer opening 3a.

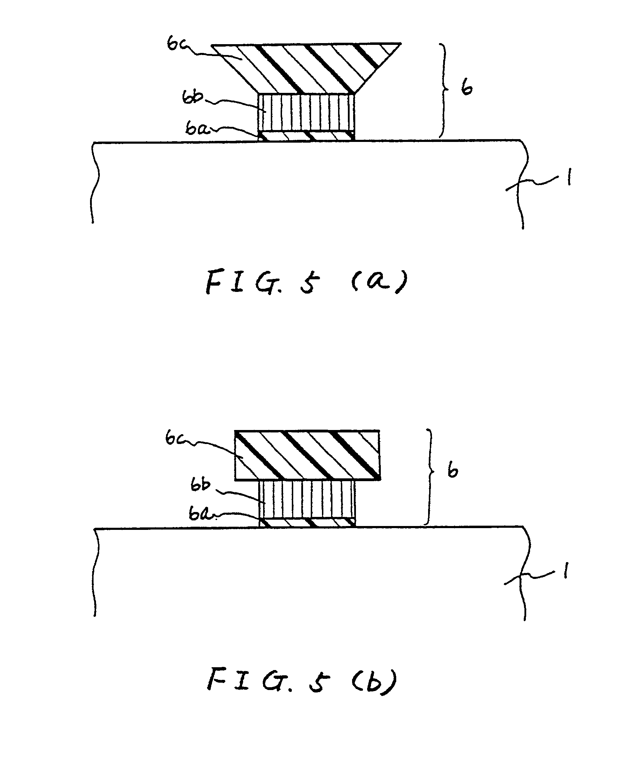

In the present embodiment, a reverse taper shape diffusion mask fabricated of silicon dioxide was used. However, in addition to this, a visor shape diffusion mask composed of multiple layers can also be used. Figures 5 (a) and 5 (b) are cross sectional views of two types of diffusion mask composed of multiple layers. The multiple layers, in sequence from the surface of the substrate 1, are a first layer of silicon dioxide film 6a, an Si3N4 layer 6b and a second silicon dioxide layer 6c. As for the second silicon dioxide layer 6c, in Figure 5a it has a reverse taper shape and in Figure 5b it has a normal taper shape. However, in either case, the structure projects horizontally outwardly in comparison to the lower first silicon dioxide layer 6a and the Si3N4 layer 6b. It is important to have the visor effect. The Si3N4 layer 6b has a permeation preventing effect towards insulating impurities. The first silicon dioxide layer 6a has a stress alleviation effect.

In a further embodiment, the production of a field emission device having a taller cathode, in which its projecting tip is placed closer to the gate electrode, will now be described.

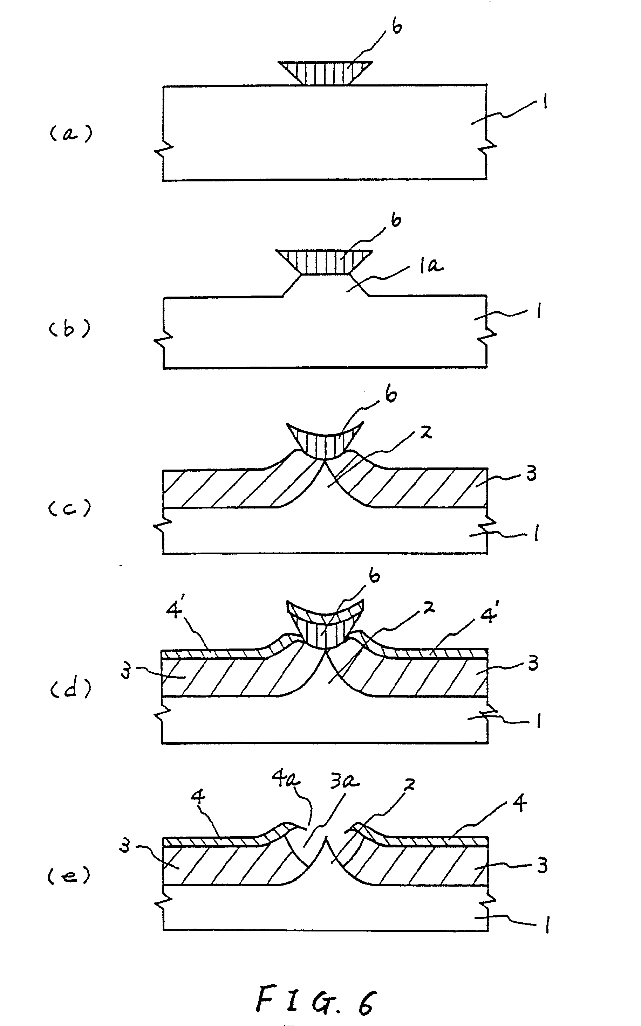

Figures 6 (a) to 6 (e) are cross sectional views of the product of each of the main production steps in the process for producing this field emission device.

First, a diffusion mask 6 is fabricated at the location in which the cathode will be formed on the surface of the substrate. A pedestal 1a is then fabricated beneath the diffusion mask 6. The diffusion mask 6 is square in plan and has a reverse taper in cross section, forming a reverse angle truncated cone shape. The lower plane, which contacts the substrate 1, has a length for each side of the square that is 5000 Å. The direction of that side matches the (110) -orientation of the single crystal silicon substrate.

The production of the diffusion mask 6 is the same as that of the diffusion mask 6 of Figure 6 (a). The pedestal 1a has a height of 3500 Å and the upper surface is a 5000 Å square truncated cone. Using the diffusion mask 6 of the etching mask, the pedestal 1a is fabricated by means of anisotropic etching of the single crystal silicon substrate 1 (Figure 6 (b)). For the anisotropic etching process, the EPW process, which uses an etching compound of an ethylene-diamine-pyrocatecol solution, is preferably used. Alternatively, the KOH process or a dry etching process can be used. The pedestal 1a, which is fabricated by means of the anisotropic etching, has four wall surfaces of (111)-, ($1\bar{1}1$)-, ($11\bar{1}$-) and ($1\bar{1}\bar{1}$)-orientation. These walls form a 54% angle relative to the surface of the substrate 1.

The following production steps, shown in Figures 6 (c) to 6 (e), are the same as the production steps described in relation to Figures 4 (b) to 4 (d) and are, therefore, not described.

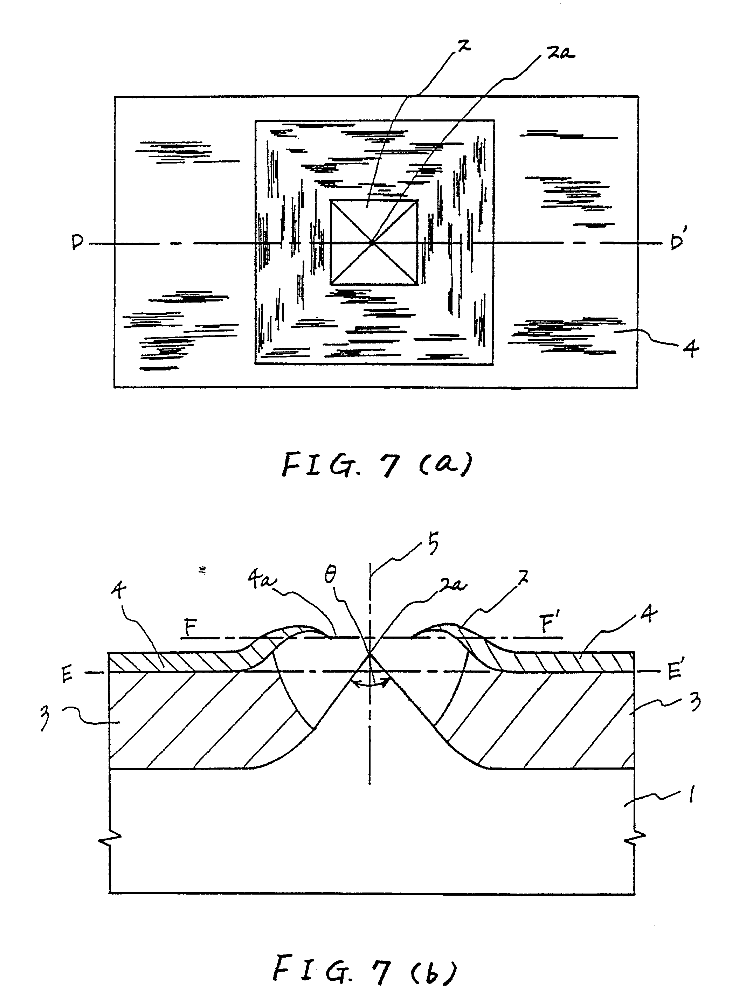

Figure 7 (a) is a plan view of the field emission device produced by this process, and Figure 7 (b) is a cross sectional view along the line D - D' of Figure 7 (a). The cathode 2 fabricated on the surface of the substrate 1 in this instance has a height of 6000 Å and is a true quadrangular pyramid. The apex angle $\theta$ in the illustrated cross section is about 70°. The perpendicular axis 5 of the pyramid passes through the centre of the gate electrode opening 4a, which is generally square in shape.

The thickness of the insulating layer 3 on the flat section of the substrate 1 is about 5000 Å. The thickness of the gate electrode 4 is about 1000 Å. As a result, the projecting tip 2a is in a higher position than the virtual plane E - E' of the insulating layer, which is generally specified at the upper plane of the insulating layer, and in a lower position than the virtual plane F - F' of the gate electrode opening, which is generally specified at the periphery of the gate electrode opening.

The shortest distance between the projecting tip 2a and the gate electrode 4 is about 2500 Å. Compared with the other embodiments described above, this field emission device has a structure in which the projecting tip 2a of the cathode 2 is closer to the gate electrode 4. This is caused by a reduction in the volume of silicon dioxide formed at the location of the projecting tip 2a as a result of using the pedestal 1a. The threshold voltage of the field emission device in this instance is $V_{th} = 70$ V (Ik = 1 uA).

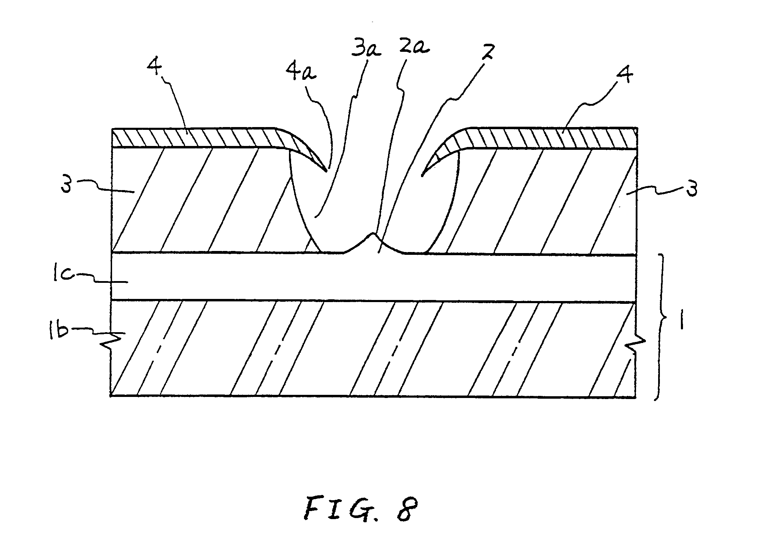

In a further embodiment, shown in Figure 8, the field emission device has a substrate composed of an insulating substrate portion and a conductive thin film that is fabricated on the surface of the insulating substrate portion.

As shown in Figure 8, this field emission device comprises a substrate 1, which is composed of a transparent quartz substrate portion 1b, and a conductive n-type polycrystalline silicon thin film 1c, which is fabricated on the surface of the quartz substrate portion 1b. The device also has a cathode 2, which is fabricated on the surface of the silicon thin film 1c as one unit therewith and of the same material. An insulating layer 3 is fabricated on the surface of the silicon thin film layer 1c, and comprises a silicon dioxide film that is open at the location of the cathode 2. A gate electrode 4, which is fabricated on the surface of the insulating layer 3, is also open at the location of the cathode 2.

The silicon thin film layer 1c has an electron concentration of about $1 \times 10^{18}$ cm$^{-3}$ and a resistivity of about 0.03 ohm centimetres. Its film thickness is about 5000 Å in planar regions thereof in which the cathode 2 does not exist. The cathode 2 is generally cone shaped with a height of about 2000 Å. The radius of curvature of the projecting tip 2a is 2000 Å or less. The film thickness of the insulating layer 3 is about 5500 Å. This layer is fabricated by thermally diffusing oxygen, which is an insulating impurity, into the silicon thin film layer 1c. The gate electrode 4 is composed of molybdenum thin film which is 1000 Å thick. The gate electrode opening 4a is a circle with a diameter of 5500 Å, which is arranged to align automatically with the cathode 2.

Except for the preparation of the substrate 1 and the thermal oxidation of the substrate, the production of this field emission device is the same as that described with reference to Figure 4. In the substrate preparation step, the n-type silicon thin film 1c is fabricated on the surface of the quartz substrate portion 1b, which is 1.1 mm thick and 15.24 cm (6 inches) in diameter. The silicon thin film 1c is a non-doped polycrystalline silicon thin film, which is 8000 Å thick and is deposited by means of low pressure CVD and whose resistance has been lowered by the thermal diffusion of phosphorous (P). In addition, the thermal oxidation conditions of the production step for providing the insulating layer 3 are that the substrate temperature be 1100°C and that vapour oxidation takes place for twenty minutes. Compared with a single crystal silicon thin film, the oxidation rate of poly-crystalline silicon is rapid, making the oxidation time shorter.

In addition, the silicon thin film can also be used for inter-connections. In such a case, if the silicon thin film is etched and separated before the thermal oxidation step, the inter-connection will be covered by the insulating layer when this is formed, making for convenient insulation separation of the inter-connections. If a transparent material is used for the insulating substrate portion 1b, the regions of the substrate in which components such as the silicon thin film 1c and the gate electrode 4 do not exist will also be transparent. As a result, if the field emission device of this embodiment is used to create a luminous display device, a brilliant display can be realised because the light emitted from the luminous layer can be recognised from the direction of the substrate 1.

In this embodiment, a silicon thin film is used as the conductive thin film and a silicon dioxide layer is used as the insulating layer. However, the invention is not limited to this combination, and other combinations of materials as shown in Table 1 below, for example, can also be employed :

## TABLE 1

| Conductive thin films | Insulating layers | | |
| --- | --- | --- | --- |
| Single crystal silicon (c-Si) | SiO2 | or | Si3N4 |
| Polycrystalline silicon (p-Si) | SiO2 | or | Si3N4 |
| Amorphous silicon (a-Si) | SiO2 | or | Si3N4 |
| Aluminium (Al) | Al2O3 | | |
| Tantalum (Ta) | Ta2O5 | | |

Here, Al2O3 and Ta2O5 may also be fabricated by diffusing oxygen, an insulating impurity, into aluminium or tantalum by means of anodic oxidation. In addition to quartz for the substrate portion 1b, if the material is one that will withstand the production process, it could be used regardless of its composition.

It is also easy to apply the production process for this embodiment to the embodiment of Figures 6 and 7, and to form a pedestal on the conductive thin film 1c and move the projecting tip 2a of the cathode 2 closer to the gate electrode 4.

Next, an embodiment of the production process of the field emission device that chiefly sharpens the projecting tip of the cathode will be described. This embodiment can be applied to all of the previously described field emission devices as well as to other field emission devices that have a cathode with a cone shape.

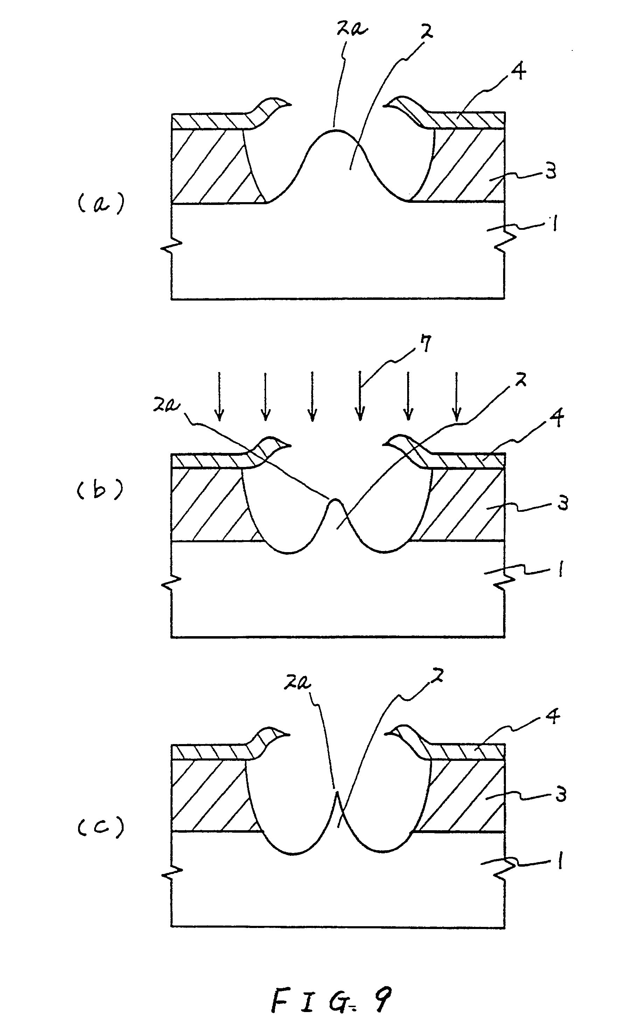

Figures 9 (a) to 9 (c) are general cross sectional views of the device before and after an additional production step, following those previously described, for sharpening the cathode of the field emission device using dry etching technology. A cathode 2 after it has completed the previous production steps sometimes has a large radius of curvature of 1000 Å (Figure 9 (a)) due to the diffusion along the interface of the impurities. Such a field emission device has a very large threshold voltage and electrical properties that are not good. Therefore, in order to give the projecting tip 2a a smaller radius of curvature and improve the electrical properties, the additional production step is used to apply etching gases 7 in the shape of a parallel beam to the cathode 2 for etching away the sides of the cathode 2 and sharpening the projecting tip 2a (Figure 9 (b)).

When the cathode 2 is made of a silicon material, carbon tetrafluoride (CF4) in a plasma form is used as the etching gas to etch the material chemically. In addition to this, physical etching, in which accelerated particles are sputtered, is also effective. This process is effective with materials other than silicon.

In spite of the fact that a field emission device with a sharpened cathode 2 has a substrate 1 that has been gouged out around the periphery of the cathode 2 and in spite of the fact that the projecting tip 2a of the cathode 2 becomes 1.5 times further away from the gate electrode 4, the radius of curvature of the projecting tip becomes 500 Å or less (Figure 9 (c)). A field emission device that has a sharp cathode as shown in Figure 9 (c) has a threshold voltage of $V_{th}$ = 55 V. The threshold voltage decreases by about 30% compared with that of the cathode before it was sharpened.

Effective methods of reducing the threshold voltage are thus :

1. decreasing the distance between the gate electrode and the cathode, and

2. reducing the radius of curvature of the projecting tip.

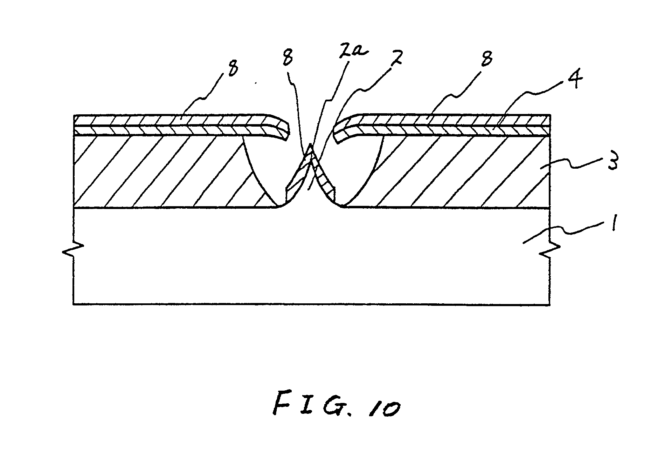

In addition to these, a method of reducing the work function of the cathode is also effective. This is simply a matter of forming a thin film layer of a material such as barium (Ba), caesium (Cs), thorium (Th), barium oxide (BaO) and thorium dioxide (ThO2) on the projecting tip. Figure 10 is a cross sectional view of a field emission device, in which a thin film layer 8 of barium is fabricated on the tip 2a of the cathode 2. The threshold voltage of this field emission device is $V_{th} = 40$ V. The existence of the barium thin film layer 8 decreases the distance between the cathode 2 and the gate electrode 4, having the effect of reducing the threshold voltage.

Next, the use of a field emission device according to the invention in a multiple-electrode electronic device will be described.

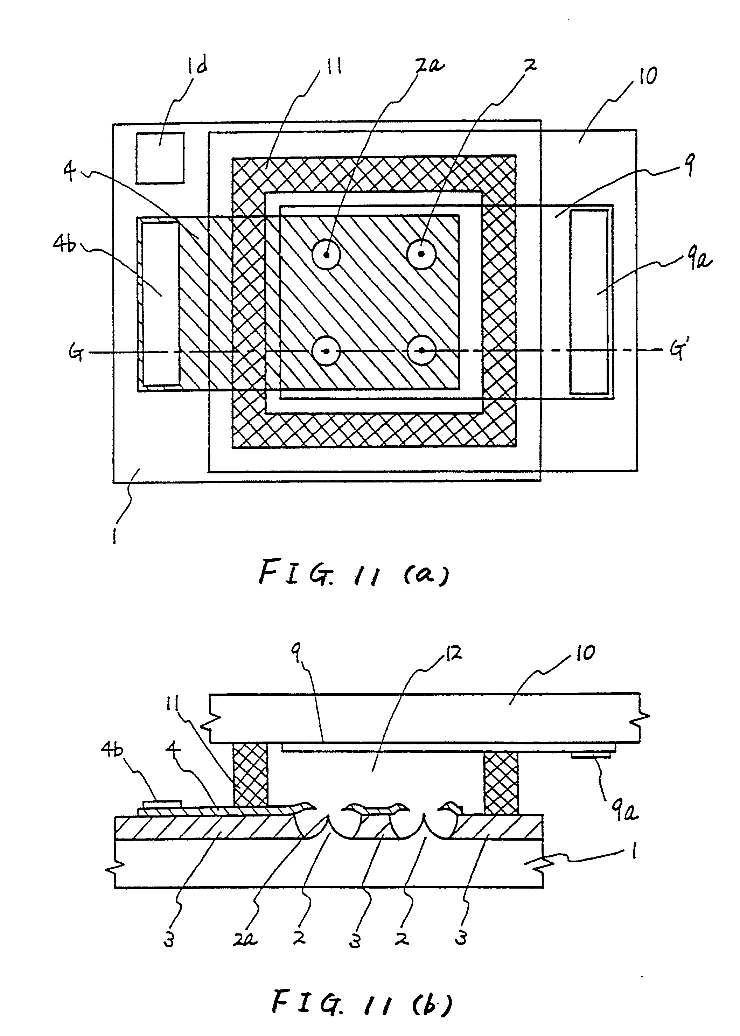

Figure 11 (a) is a plan view of a vertical three-electrode device. Figure 11 (b) is a cross sectional view along the line G - G' of Figure 11 (a). The three electrode device is a vacuum transistor that has three electrodes : a cathode, a gate electrode and an anode, in a vacuum. It is an electronic device that controls electron current by means of the electrical potential of each electrode. The vertical three electrode device has a structure that includes a first substrate, the substrate 1 of the field emission device with the cathode 2 and gate electrode 4 on its surface, and an opposing substrate 10, which has an anode 9 on its surface. A supporting structure 11 supports the substrates 1, 10 so that the cathode 2 and the anode 9 face each other. A vacuum is maintained in the space between these.

The field emission device is produced according to the process described with reference to Figures 6 (a) to 6 (e). Four field emission devices are placed in an array and they share a common gate electrode 4. The opposing substrate 10 is a flat glass substrate. Its thermal expansion coefficient matches that of the substrate 1 to within a tolerance of 10%. The anode 9 is composed of a tungsten material. The supporting structure 11 is composed of the same material as the opposing substrate 10. This structure 11 is fabricated around the field emission devices and is adhered to each of the substrates 1 and 10 by means of low temperature dissolution glass to seal the device.

The vacuum layer 12 is maintained at a vacuum of $1 \times 10^{-7}$ Torr by means of a BaAl4 gettering material that is evaporated by means of optical heating. For the output to the external circuits from each electrode, a cathode pin 1d, gate pin 4b and anode pin 9a are used. This vertical three electrode device has a distance between the cathode 2 and the gate electrode 4 (the distance between G - K) of 2500 Å. The distance between the cathode 2 and the anode 9 (the distance between A-K) is 50 microns. In addition, the dimensions of the vacuum layer 12 are 200 microns vertically and 200 microns horizontally, with a thickness of 50 microns.

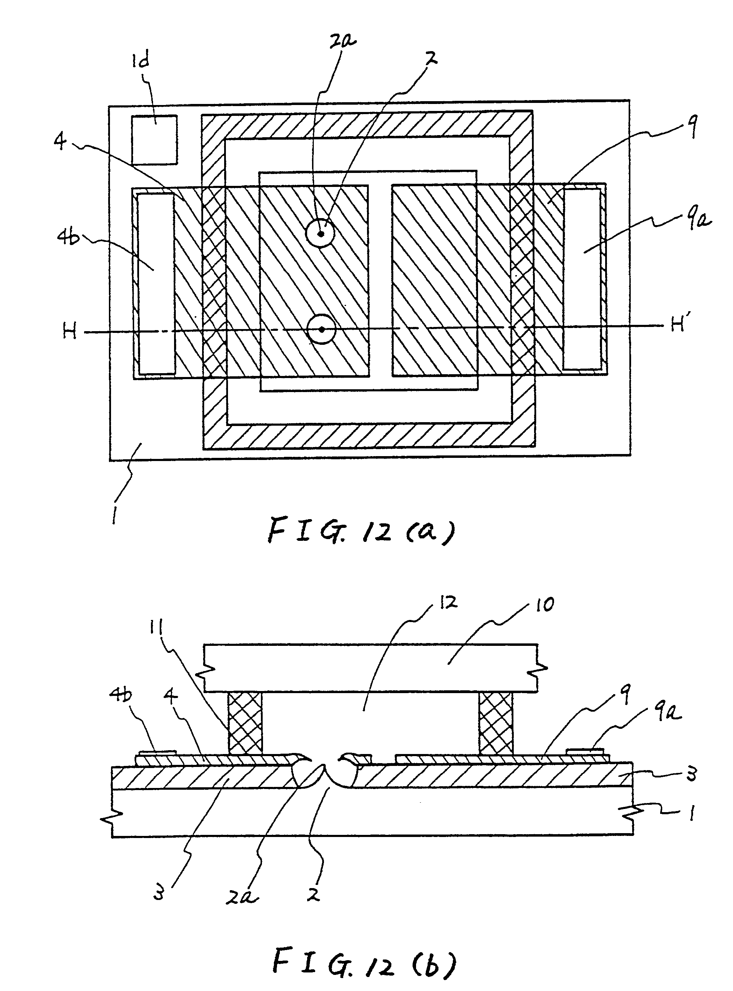

Figure 12 (a) is a plan view of a horizontal three electrode device. Figure 12 (b) is a cross sectional view along the line H - H' of Figure 12 (a). The same parts as in Figure 11 are identified by the same reference numerals. The horizontal three electrode device has a structure that aligns the field emission devices and the anode 9 horizontally on the surface of the substrate 1. The difference between the horizontal three electrode device and the vertical three electrode device is that the anode 9 and the gate electrode 4 are fabricated on the same layer in the horizontal three electrode device. Otherwise, its construction is the same as that of the vertical three electrode device shown in Figure 11.

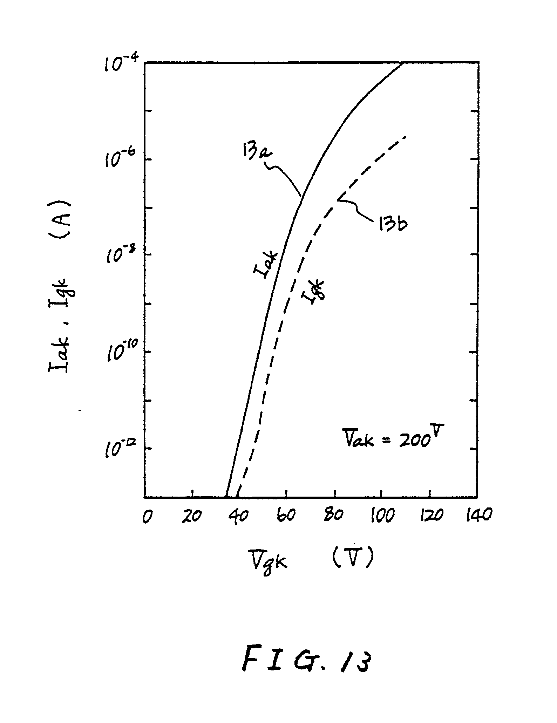

Figure 13 shows the voltage-to-current (V - I) static characteristics of the previously described vertical three electrode device, in a condition in which the cathode 2 is grounded and the anode voltage is constant at $V_{ak} = 200$ V. The graph measures gate voltage $V_{gk}$ versus gate current 13a ($I_{gk}$) and anode current 13b ($I_{ak}$).

The gate and anode currents $I_{gk}$ and $I_{ak}$ increase exponentially relative to $V_{gk}$, indicating a current that is an FN tunnel current. What needs to be heeded here is the point that regardless of the gate voltage $V_{gk}$, the current ratio ($I_{ak}/I_{gk}$) is almost constant at 30. That is, if the vertical three electrode device is controlled in the current mode, the output ($I_{ak}$) has a proportional relationship to the input ($I_{gk}$) and it becomes a linear current amplifier with a current amplification ratio of 30.

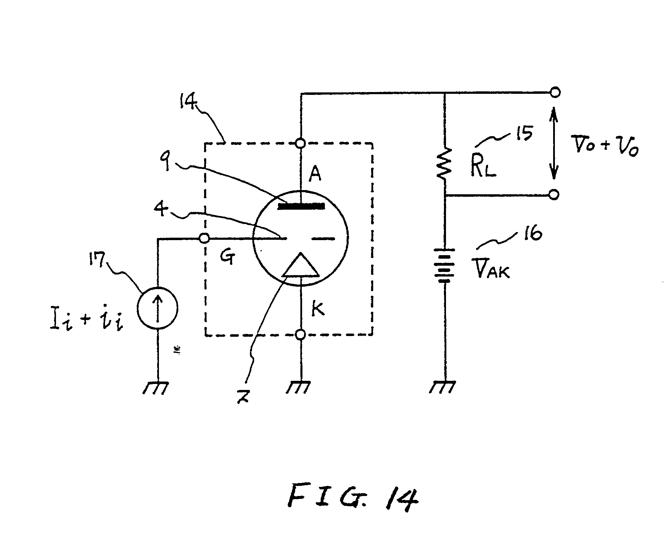

Figure 14 is a circuit diagram for a linear amplifier using such a vertical three electrode device. It is configured so that the cathode 2 of the three electrode device is grounded and the anode bias voltage 16 (Vak) of the anode 9 and the load resistance 15 (RL) are connected in series. If an input current 17 ($I_l + i_i$), which is a bias current $I_l$ weighted by the micro-signal current $i_i$, are input to the gate electrode 4, an output voltage represented by equation (1) below will appear on both ends of the load resistance 15 :

$$\overline{V} + vo = -a \cdot RL \cdot (I_l + i_i) \equiv -a \cdot RL \cdot I_l -a \cdot RL \cdot ii \quad (1)$$

As a result, from equation (1), a micro-signal current $i_i$, in which the output voltage vo, which is increased by $-a \cdot RL$ times, will be obtained. This characteristic can be obtained in the same manner with horizontal three electrode devices as well.

In addition, by turning on and off the gate voltage, the three electrode device can also switch the anode current. A three electrode device that possesses these kinds of properties is used in audio power amplifiers and the drive circuits of brushless motors.

Furthermore, as a material for the three electrode device anode 9, materials that emit x-rays, such as copper (Cu), can be used. An x-ray generating device can be made from such a three electrode device by means of exciting electrons emitted from a field emission device. This x-ray generating device can become a source of micro-beam x-rays because it can reduce the x-rays to the micro level of tens of microns or less.

A luminous display device that uses the field emission device according to the present invention will now be described. Such a luminous display device has pixels, which are made of field emission device groups and a luminous layer, arranged in a matrix. In order to obtain the desired display pattern with each selected pixel, the luminous layer is excited and made to illuminate by means of electrons from the field emission device, creating a patterned display.

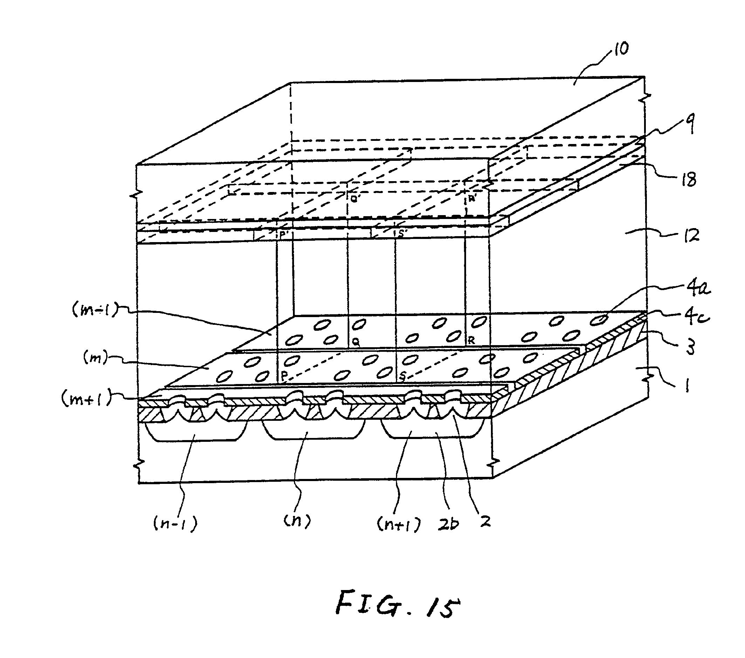

Figure 15 is an isometric drawing of a simple matrix luminous display device. This device comprises chiefly a substrate 1, which has on its surface a multiplicity of cathode lines 2b in a stripe configuration, a multiplicity of gate lines 4b arranged in a stripe configuration that is orthogonal to the cathode lines 2b, and a multiplicity of regions in which field emission device groups have been fabricated where the cathode lines 2b cross the gate lines 4b at right angles. This device also comprises an opposing substrate 10, which is arranged opposite the substrate 1 and which has thereon on anode 9 and a stacked luminous layer 18 that almost covers the entire surface thereof. A vacuum layer 12 is maintained between the two substrates.

Each pixel is composed of a field emission device group and an opposing luminous layer region. That is, a pixel at address (m, n) is composed of the field emission device group fabricated within the intersecting region p q r s of the nth cathode line and mth gate line and of the corresponding luminous layer region p' q' r' s' of the opposing substrate 10.

The substrate 1 is a p-type single crystal silicon substrate, and the cathode lines 2b are composed of an n-type layer of silicon fabricated on the surface of the substrate 1. In addition, the cathodes 2 are fabricated on the surface of the same n-type silicon layer in the intersecting regions of the cathode lines 2b. The production process of components such as the cathode 2, the insulating layer 3 and the gate electrode opening 4a is similar to that described with reference to Figures 6 (a) to 6 (e). The opposing substrate 10 is a transparent glass substrate. The anode 9 is composed of a material, such as ITO, providing a transparent conductive layer. The illumination of the luminous layer 18 is transmitted through these and is recognised from the direction of the opposing substrate 10.

This simple matrix luminous display device operates by means of a multiplex drive method, in which the cathode line 2b (or gate line 4c) is the segment line and the gate line 4c (or cathode line 2b) is a common line. In this case, it is important to set the drive voltage and wave form so that the electrical potential of the n-type silicon layer, that is the electrical potential of the cathode line 2b, does not become negative in relation to the electrical potential of the p-type single crystal silicon substrate.

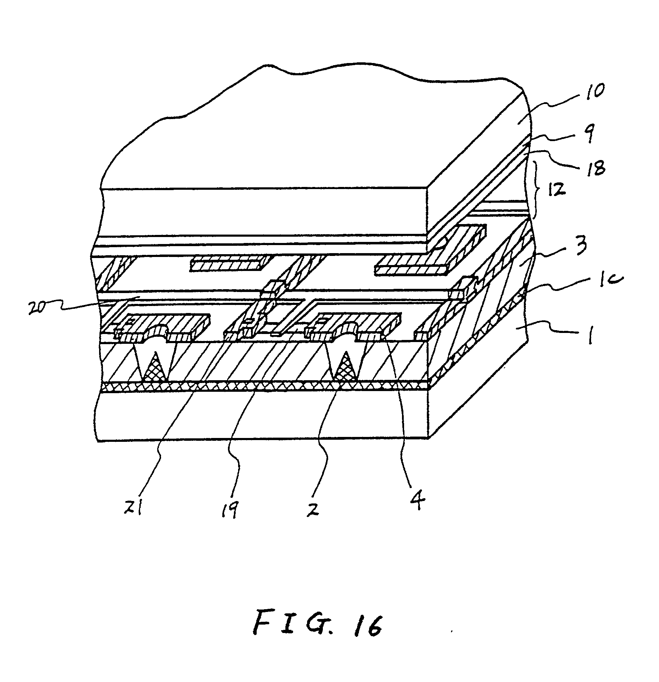

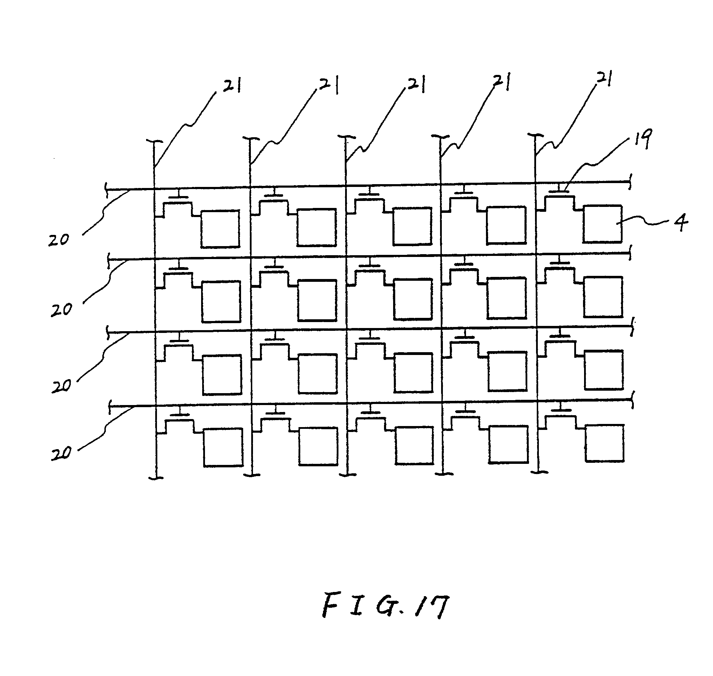

Figure 16 is a partial isometric drawing of an active matrix luminous display device and Figure 17 is a partial schematic plan view of this active matrix luminous display device. Thin film transistors (TFT) are fabricated for each pixel, and voltage is applied through the TFT to the gate electrode of the selected pixel and the display occurs.

The main elements of this device are TFT gate lines 20 and TFT source lines 21, which are fabricated in a lattice configuration on the surface of the transparent substrate 1, and TFTs 19 and field emission device groups that are fabricated at the intersecting regions of these lines and are arranged in a matrix configu-ration. The anode 9 and luminous layer 18 are stacked on the surface of the opposing substrate 10, which is essentially arranged to define one side of the vacuum layer 12.

The field emission device groups are produced in the same manner as described with reference to Figure 8. They have the silicon thin film layer 1c as a common cathode inter-connection. The TFT drain pin is connected to the gate electrode 4. The TFT gate pin is connected to the TFT gate line 20. The TFT source pin is connected to the TFT source line 21. As thin film transistors, polycrystalline silicon TFTs, amorphous silicon TFTs or CdSe TFTs can be used.

The method of driving this device is as follows : If a data voltage is applied to the TFT source line 21 and a selective voltage is applied to turn on the TFTS at the TFT gate lines 20 (scanning lines), the TFTs that align with this source line will turn on and the data voltage will be applied to the gate electrode 4 of each pixel through the TFT channels. As a result of this data voltage, electrons that will provide the desired brightness in the luminous layer 18 will be emitted from each field emission device and a pixel display will be created. The pixel display will appear as a result of performing this display operation in sequence for each scanning line.

In addition, if luminous material that gives off red (R), green (G) and blue (B) at each pixel is arrayed as the luminous layer 18, a multiple colour or a full colour luminous display device can be created. Moreover, the illumination of the luminous layer 18 can be recognised from the direction of the opposing substrate 10. However, if the substrate 1 were transparent and the electrodes and wiring used on the substrate 1 were either very fine or transparent, it would also be easy to recognise the illumination in the direction of the substrate 1.

The luminous display device described in this embodiment, which handles either monochrome or colour displays, has the characteristics of low power consumption and flatness. Making the most of these characteristics, such a display is quite suitable as a terminal display device of portable information equipment, such as flat, wall mounted televisions, light weight portable televisions, lap top computers and palm top computers, as well as being quite suitable as an image light source for electronic view finders of portable VTRs and for projection display devices. In addition, it can also be used in alpha-numeric displays, time displays for wrist watches, and display devices for games machines by configuraing a seven segment character display device or a special miniature display device.

An optical printer head that uses the field emission device according to the invention will now be described.

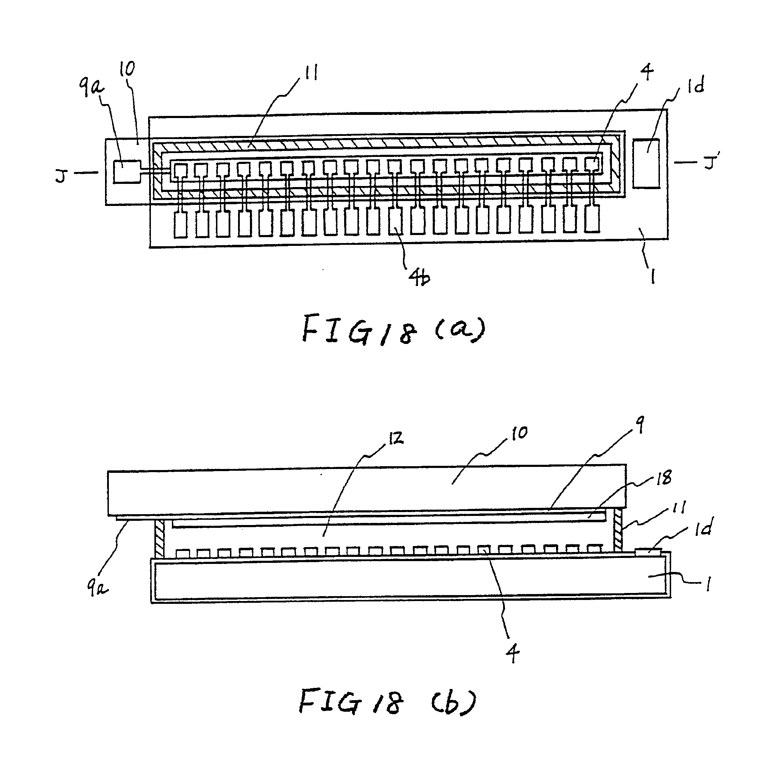

Figure 18 (a) is a plan view of a monochrome optical printer head and Figure 18 (b) is a cross sectional view along the line J - J' of Figure 18 (a). In this printer head, pixels, which are composed of the field emission device groups and a luminous layer, are aligned in a row. Optional pixels are lighted by means of the voltage applied to each gate electrode 4 or anode 9. This optical printer head can easily be made to serve as an RGB three light source by arranging in a row three different luminous materials. The control of the luminous status of each pixel through data signals takes place through a device such as a discrete LSI chip, which is fabricated as a hybrid, through the circuit of a silicon LSI device or through the TFT circuit of a silicon LSI device, or through COG technology. The monochrome or colour optical printer head can be used as the line optical source of colour optical printers, such as xerography type optical printers, silver salt photography printers or light sensitive colouring printers.

The field emission device and its production process according to the present invention have various advantages listed below :

(1) The cathode and gate electrode are automatically aligned during fabrication, and the cone shape and size and, therefore the uniformity of the electrical characteristics, are excellent.

(2) The invention allows for substantial flexibility in use, because many types of substrates, for example glass substrates, semi-conductor substrates or conductive substrates, can be employed.

(3) The insulating layer is of high quality, and it is superior in electrical characteristics and insulation strength for example. It also has high reliability, which is good for high voltage power devices including the field emission device according to the present invention.

(4) Because the production process suits semiconductor VLSI technology, drive circuits and other circuits can be fabricated on the same substrate, making it easy to fabricate a compound and multi-functional device, and making the invention suitable to the fabrication of intelligent devices.

## Claims

1. A field emission device comprising a substrate (1), a cathode (2) projecting on the surface of the substrate, an insulating layer (3) provided on the surface of the substrate, which insulating layer is open at the location of the cathode, and a gate electrode (4) provided on the surface of the insulating layer, which gate electrode is open at the location of the cathode, characterised in that the insulating layer and the cathode comprise the same basic material with the insulating layer containing insulating impurities for converting the material into an insulating material.

2. A field emission device according to claim 1, characterised in that the insulating layer and the cathode comprise the same basic material as the substrate, the cathode being integral with the substrate.

3. A field emission device according to claim 1 or 2 characterised in that the cathode has a thin film layer (8) on its projecting tip, the thin film layer being formed from one of barium, caesium, thorium, barium oxide and thorium oxide.

4. A process for producing a field emission device comprising fabricating a cathode (2) projecting from the surface of a substrate (1), fabricating an insulating layer (3) on the surface of the substrate, which insulating layer is open at the location of the cathode, and fabricating a gate electrode (4) on the surface of the insulating layer, which gate electrode is open at the location of the cathode, characterised in that the steps of fabricating the cathode and the insulating layer comprise forming both the cathode and the insulating layer from a layer of a material by supplying insulating impurities into a portion only of said layer of material for forming the insulating layer whilst leaving another portion of said layer of material as the cathode.

5. A process according to claim 4 characterised in that the forming step comprises fabricating a diffusion mask (6) on the surface of the substrate and diffusing insulating impurities into the masked surface of the substrate.

6. A process according to claim 5 characterised in that the step of fabricating the diffusion mask comprises forming the diffusion mask with a reverse taper.

7. A process according to claim 5 or 6 characterised by forming the diffusion mask on a pedestal (1a) provided by the substrate.

8. A process according to any of claims 5 to 7 characterised in that the step of fabricating the gate electrode comprises forming a gate electrode layer (4') on the surface of the insulating layer and on an upper surface of the diffusion mask, and removing the diffusion mask to provide an opening in the gate electrode layer at the location of the cathode.

9. A process according to any of claims 4 to 8 characterised in that the step of fabricating the insulating layer comprises removing a portion of the insulating layer to form an opening at the location of the cathode.

10. A process according to any of claims 4 to 9 characterised by dry-etching the surface of the cathode.

FIG. 1 (a)

FIG. 1 (b)

F I G. 2

FIG. 3

(a)

(b)

(c)

(d)

FIG. 4

FIG. 5 (a)

FIG. 5 (b)

FIG. 6

FIG. 7 (a)

FIG. 7 (b)

FIG. 8

**F I G. 9**

FIG. 10

FIG. 11 (a)

FIG. 11 (b)

F I G. 12 (a)

F I G. 12 (b)

$FIG. 13$

FIG. 14

FIG. 15

FIG. 16

F I G. 17

FIG 18 (a)

FIG 18 (b)